# EUROPEAN PATENT SPECIFICATION

(11) **EP 0 800 270 B1**
(45) Date of publication and mention of the grant of the patent: **10.09.2003**
(21) Application number: 97105462.2
(22) Date of filing: 02.04.1997
(51) Int. Cl.: H03H 9/64

(54) **Surface acoustic wave filter**
Akustischer Oberflächenwellenfilter
Filtre à ondes acoustiques de surface

(30) Priority: 02.04.1996 JP 7979396
(43) Date of publication of application: 08.10.1997
(73) Proprietor: MATSUSHITA ELECTRIC INDUSTRIAL CO., LTD., Kadoma-shi, Osaka 571-0050 (JP)
(72) Inventor: Taguchi, Yutaka, Takatsuki-shi, Osaka 569 (JP); Eda, Kazuo, Nara-shi, Nara 631 (JP); Seki, Shun-ichi, Amagasaki-shi, Hyogo 661 (JP); Onishi, Keiji, Settsu-shi, Osaka 566 (JP); Murase, Yasumichi, Nishinomiya-shi, Hyogo 663 (JP); Nishimura, Kazunori, Yawata-shi, Kyoto 614 (JP); Mita, Narihiro, Izumisano-shi, Osaka 598 (JP)
(74) Representative: Eisenführ, Speiser & Partner

(56) References cited:
- EP-A- 0 605 884
- EP-A- 0 698 965
- EP-A- 0 772 293
- EP-A- 0 786 861
- WO-A-97/00556
- JP-A- 1 231 417

## Description

### FIELD OF THE INVENTION

The present invention relates to a surface acoustic wave (SAW) filter provided with a distributor function, and more particularly to a surface acoustic wave filter for use in a high frequency region such as RF-band.

### BACKGROUND OF THE INVENTION

In recent years, research has been carried out briskly on a surface acoustic wave element for use in a filter. In particular, a recent advancement of mobile communication and a higher frequency has led to a brisk development of a surface acoustic wave element, particularly a surface acoustic wave filter.

EP-A-0 605 884 discloses an IIDT (Interdigited Interdigital Transducer) type surface acoustic wave filter comprising a piezoelectric substrate and at least three IDTs (Interdigital Transducers) which are arranged on a surface of the piezoelectric substrate along the direction of surface wave propagation. The IDT is inverted in phase with respect to the other IDT while these IDTs are connected in series to each other through the ground potential, thereby balancing inputs or outputs.

EP-A-0 786 861 representing prior art according to Art. 54(3) EPC discloses a surface acoustic wave filter comprising a piezoelectric substrate, surface wave reflectors formed with an interval therebetween on the piezoelectric substrate, and interdigital transducers interposed between the surface wave reflectors on the piezoelectric substrate. The interdigital transducers comprise a central interdigital transducer for input and at least two side interdigital transducers, at least one located at one of opposite sides of the central interdigital transducer and the other one located at the other one of opposite sides of the central interdigital transducer. The central interdigital transducer for input comprises a pair of first comb-like electrodes provided with an input terminal and second comb-like electrodes provided with a further terminal. Each of the side interdigital transducers for output comprises a pair of first comb-like electrodes provided with a connecting terminal and second comb-like electrodes provided with an output terminal, wherein the connecting terminals are connected to each other or grounded together and the output terminals are connected to each other.

In EP-A-0772293 representing prior art according to Art. 54(3) EPC with respect to the designated states DE, GB and SE, there is described an electro-acoustic device, comprising a piezo-electric substrate and a first transducer and second transducer supported by the substrate and each including a part of interdigital transducer electrode arrays, the electrodes of the arrays being interleaved with each other. The first and second transducer are disposed opposing each other in a propagation direction of acoustic waves excited by the first and second transducers. The first transducer has a first electric signal associated with and existing across, and the second transducer has a second electrical signal associated with it which has a different phase from the first electrical signal. The first and second transducers are spaced apart such that substantially in-phase acoustic waves propagating in the substrate and incident on the first transducer in-phase with the first electric signal and on the second transducer in-phase with the second electrical signal. Preferably, the first and second transducers are spaced apart by an integer number of half acoustic wavelengths corresponding to an operating frequency of the device. This permits differential or balanced driving of the device. There are further disclosed examples of such a device utilised in transversely and in-line coupled resonator filters to provide balanced or differential inputs or outputs thereto, and to facilitate cascade connected coupled resonator filters having no ground loops.

Conventionally, there are known several kinds of methods for constituting a filter of a surface acoustic wave element in a high frequency region, particularly in several hundred MHz such as RF-band (950 MHz). Typical methods of such kinds include a method of ladder type for constituting a filter by using a plurality of surface acoustic resonators as disclosed in JP-A-52-19044, a method of so-called multiple electrode type as disclosed in JP-A-58-154917, a method of vertical mode type as disclosed in JP-A-3-2225112, JP-A-61-230419 and JP-A-1-231417 wherein surface acoustic wave resonators are located adjacent to each other to use a coupling between resonators.

These SAW filters all were dealing with an unbalanced type signal, and their characteristic impedance were set to 50 ohms because of a demand from a user side of the SAW filters. Further, these SAW filters had no distributor function therein, so a separate distributor must be used to distribute one input signal into more than two output signals.

In recent years, there is seen a movement of decreasing the number of parts by allowing parts of a high frequency circuit to incorporate a plurality of functions. Such movement has arisen from a demand on a miniaturization and a cost reduction of such parts. It seems that such a demand will get stronger from now on. As one of such examples, there has been desired a new filter provided with a distributor function. Further, there has been desired a new filter provided with a function for a balanced circuit in order to get a higher performance of the high frequency circuit. In this case, parts for balanced circuit will be required and their characteristic impedance will not be set to 50 ohms similar to that in the conventional unbalanced circuit.

In particular, during a transition period from an unbalanced circuit to a balance circuit, there were required parts such as a balun which has an unbalanced terminal for input and a balanced terminal for output. Although the balun is capable of controlling the impedance of the balanced terminal and the unbalanced terminal depending on the structure thereof, there happened a disadvantage in that the cost was increasing and more package area was required for mounting the balun.

### SUMMARY OF THE INVENTION

Therefore, a first object of the present invention is to provide a new surface acoustic wave filter provided with the, distributor function. Further, a second object of the present invention is to provide a new balanced-unbalanced type surface acoustic wave filter without using the balun.

In order to achieve the above and further objects, in accordance with a first aspect of the present invention which is valid for the designated state FI, there is provided a surface acoustic wave filter comprising a piezoelectric substrate, surface wave reflectors formed with an interval therebetween on said piezoelectric substrate, and interdigital transducers interposed between said surface wave reflectors on said piezoelectric substrate; wherein
said interdigital transducers comprise a central interdigital transducer for input, at least two side interdigital transducers, at least one located at one of opposite sides of said central interdigital transducer and the other one located at the other one of opposite sides of said central interdigital transducer,
said central interdigital transducer for input comprises a pair of first comb-like electrodes provided with an input terminal and second comb-like electrodes provided with a grounding terminal,
each of said side interdigital transducers for output comprises a pair of first comb-like electrodes provided with a connecting terminal and second comb-like electrodes provided with an output terminal,
said output terminals are provided separately from each other so as to distribute one signal entering into said central interdigital transducer into at least two signals each outputted from each output terminal of said side interdigital transducers, respectively, and
said connecting terminals are connected to each other and not connected to ground.

Moreover, in accordance with a second aspect of the present invention which is valid for the designated states DE, GB and SE, there is provided a surface acoustic wave filter comprising:
a piezoelectric substrate, surface wave reflectors formed with an interval therebetween on said piezoelectric substrate, and interdigital transducers interposed between said surface wave reflectors on said piezoelectric substrate; wherein
said interdigital transducers comprise a central interdigital transducer for input, at least two side interdigital transducers, at least one located at one of opposite sides of said central interdigital transducer and the other one located at the other one of opposite sides of said central interdigital transducer,
said central interdigital transducer for input comprises a pair of first comb-like electrodes provided with an input terminal and second comb-like electrodes provided with a grounding terminal,
each of said side interdigital transducers for output comprises a pair of first comb-like electrodes provided with a connecting terminal and second comb-like electrodes provided with an output terminal,
said output terminals are provided separately from each other so as to distribute one signal entering into said central interdigital transducer into at least two signals each outputted from each output terminal of said side interdigital transducers, respectively,
said connecting terminals are connected to each other and not connected to ground, and the number of electrodes of each said side interdigital transducer for output is smaller than that of said central interdigital transducer for input so as to get a larger impedance of said side interdigital transducer.

Further advantageous embodiments are defined in the dependent claims.

### BRIEF DESCRIPTION OF THE DRAWINGS

Fig. 1 is a structural view showing the surface acoustic wave filter according to embodiment 1 of the invention.

Fig. 2 is a measurement circuit diagram according to embodiment 1 of the invention.

Fig. 3 is a structural view showing the surface acoustic wave filter according to embodiment 2 of the invention.

### DETAILED DESCRIPTION OF THE INVENTION

Embodiments of the present invention will be explained hereinafter.

### Embodiment 1

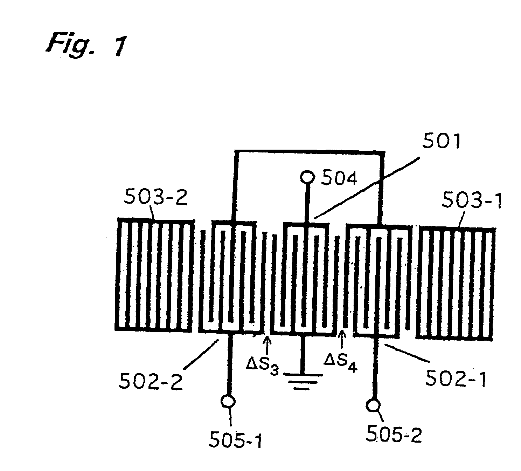

Embodiment 1 of the invention is now described. As a piezoelectric substrate, a 64° Y cut transmission lithium niobate substrate is used to constitute a filter. A structure of electrodes is shown in Fig. 1.

Reference numeral 501 denotes an interdigital transducer for input comprising a pair of 1) first comb-like electrodes each positioned at one wavelength interval in a parallel manner and provided with an input terminal 504 and 2) second comb-like electrodes each positioned at one wavelength interval in a parallel manner and provided with a grounding terminal, each of said first electrodes being interposed at a half wavelength between corresponding second electrodes. Reference numerals 502-1 and 502-2 denote interdigital transducer for output comprising a pair of first comb-like electrodes each positioned at one wavelength interval in a parallel manner and provided with a connecting terminal and second comb-like electrodes each positioned at one wavelength interval in a parallel manner and provided with an output terminal 505-1 and 505-2, each of said first electrodes being interposed at a half wavelength between corresponding second electrodes. Reference numerals 503-1 and 503-2 denote reflectors. However, for simplification, the interdigital transducer electrodes and the reflectors are described in decreased numbers in the drawings. Reference numerals 505-1 and 505-2 denote output terminals while the other terminals are connected to each other. The filter is constituted in such a manner that a space ΔS3 between the innermost electrode of the side interdigital transducer 502-2 and the outermost electrode of the central interdigital transducer 501 are equal to a space ΔS4 between the innermost electrode of the side interdigital transducer 502-1 and the outermost electrode of the central interdigital transducer 501. As a consequence, both signal output from the side interdigital transducer electrodes have an equal size and a phase different by 180° to each other.

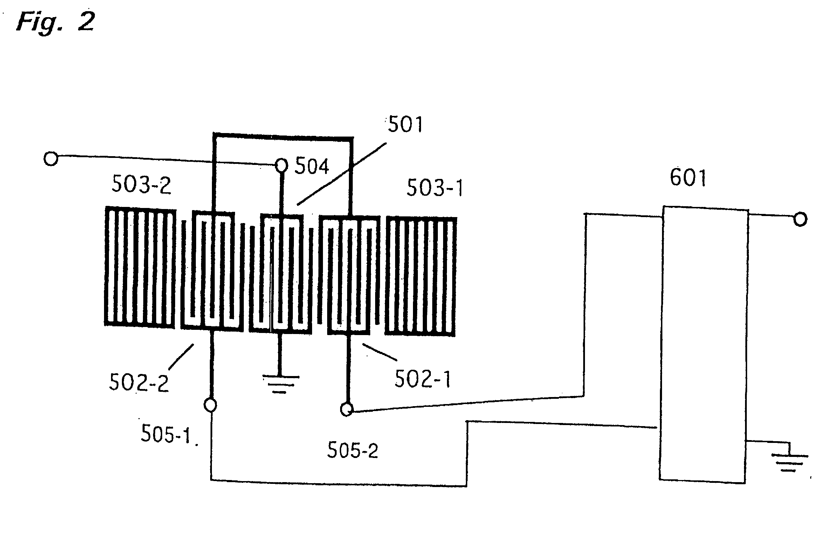

The property of this filter was measured by connecting a balun 601 which can convert signals between a 50 ohm unbalanced signal and a 200 ohm balanced signal as shown in Fig. 2, through which the balanced signal form the output 505-1 and 505-2 are converted into unbalanced signals. As a result of measurement, approximately the same property can be obtained as in the case of the conventional unbalanced signal. Besides, it was confirmed that the phase difference between output terminals can be set to 180°. So, in such a structure, it is possible to form a structure in which the input signal is an unbalanced signal and the output signals are balanced signals.

In a case of 50 ohms of input impedance, 200, 100 or 50 ohms of output impedance can be obtained depending on a ratio of the central interdigital transducer to the side interdigital transducer with respect of the number of electrode pairs.

### Embodiment 2

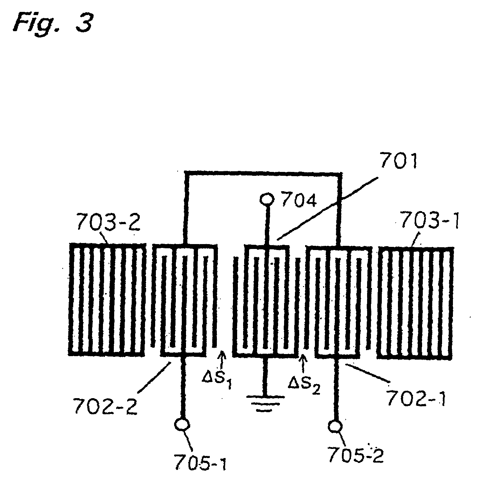

Next, embodiment 2 of the invention is shown in Fig.3. As a piezoelectric substrate, a 64° Y cut transmission lithium niobate substrate is used to constitute a filter. Reference numeral 701 denotes a central interdigital transducer electrode for input. Reference numerals 702-1 and 702-2 denote side interdigital transducers for output. Reference numerals 703-1 and 703-2 denote reflectors, reference numeral 704 denotes an input terminal, and reference numerals 705-1 and 705-2 denote output terminals. However, for simplification, the interdigital transducer electrodes and the reflectors are described in decreased numbers in the drawings.

The filter according to embodiment 2 is constituted in such a manner that spaces ΔS1 and ΔS2 at the right side and the left side between the innermost electrode of each of the interdigital transducer electrodes 702-1 and 702-2 and the outermost electrode of the central interdigital transducer 701 differ from each other by one half wavelength of surface acoustic wave generated on the piezoelectric . The side interdigital transducers 702-1 and 702-2 at both ends comprises first comb-like electrodes provided with a connecting terminals connected to each other and also second comb-like electrodes provided with the output terminals 705-1 and 705-2 used as a signal line, whereby a signal is applied between signal lines 705-1 and 705-2 of the side interdigital transducer electrodes at both ends. As a consequence, each signal output from the side interdigital transducer electrodes has an equal size and a phase different by 180° to each other. In other words, in such a structure, it is possible to form a structure in which the input signal is an unbalanced signal and the output signals are balanced signals.

By finely adjusting the space difference (ΔS1 - ΔS2), it is possible to control a phase shift between the balanced output terminals 705-1 and 705-2 if the output signal would shift by some degrees from the predetermined phase.

Furthermore, as a piezoelectric body for forming a surface acoustic wave resonators, a 64° Y cut transmission lithium niobate substrate was used, but it goes without saying that a similar advantage can be provided by using, for example, the similar piezoelectric body, for example, a lithium tantalate, a crystal substrate or the like.

In another embodiment, in spite of the interdigital transducer comprising one central interdigital transducer for input and two side interdigital transducer for output, the interdigital transducer may comprises two interdigital transducer for input and three interdigital transducers, one for input interposed between the first and the second transducers for output and the other for input interposed between the second and the third transducers for output.

## Claims (Claims for the following Contracting State(s): DE, GB, SE)

1. A surface acoustic wave filter comprising:
a piezoelectric substrate, surface wave reflectors (503-1, 503-2; 703-1, 703-2) formed with an interval therebetween on said piezoelectric substrate, and interdigital transducers (501, 502-1, 502-2; 701, 702-1, 702-2) interposed between said surface wave reflectors (503-1, 503-2; 703-1, 703-2) on said piezoelectric substrate; wherein
said interdigital transducers comprise a central interdigital transducer (501; 701) for input, at least two side interdigital transducers (502-1, 502-2; 702-1, 702-2), at least one located at one of opposite sides of said central interdigital transducer (501; 701) and the other one located at the other one of opposite sides of said central interdigital transducer (501; 701),
said central interdigital transducer (501; 701) for input comprises a pair of first comb-like electrodes provided with an input terminal (504; 704) and second comb-like electrodes provided with a grounding terminal,
each of said side interdigital transducers (502-1, 502-2; 702-1, 702-2) for output comprises a pair of first comb-like electrodes provided with a connecting terminal and second comb-like electrodes provided with an output terminal (505-1, 505-2; 705-1, 705-2),
said output terminals (505-1, 505-2; 705-1, 705-2) are provided separately from each other so as to distribute one signal entering into said central interdigital transducer (501; 701) into at least two signals each outputted from each output terminal (505-1, 505-2; 705-1, 705-2) of said side interdigital transducers (502-1, 502-2; 702-1, 702-2), respectively,
said connecting terminals are connected to each other and not connected to ground, and
the number of electrodes of each said side interdigital transducer for output is smaller than that of said central interdigital transducer for input so as to get a larger impedance of said side interdigital transducer.

2. The surface acoustic wave filter according to claim 1, wherein the number of electrodes of said central interdigital transducer for input is substantially equal to that of each said side interdigital transducer for output.

3. The surface acoustic wave filter according to claim 1, wherein a space between said second comb-like electrodes provided with an outputting terminal of said first side interdigital transducer and said first comb-like electrodes provided with an inputting terminal of said central interdigital transducer is different at one or odd number times of half wavelength (λ/2) from a space between said second comb-like electrodes provided with an outputting terminal of said second side interdigital transducer and said first comb-like electrodes provided with an inputting terminal of said central interdigital transducer, whereby one unbalanced input signal entering into said central interdigital transducer is distributed into at least two output signals having balanced relation to each other with respect to phase.

4. The surface acoustic wave filter according to claim 1, wherein the space (ΔS₁) between an innermost electrode of said first side interdigital transducer and one outermost electrode of said central interdigital transducer being different at one or odd number times of half wavelength (λ/2) from the space (ΔS₂) between an innermost electrode of said second side interdigital transducer and an other outermost electrode of said central interdigital transducer.

5. The surface acoustic wave filter according to claim 1, wherein the space (ΔS₃)between an innermost electrode of said first side interdigital transducer and one outermost electrode of said central interdigital transducer being substantially the same as the space (ΔS₂) between an innermost electrode of said second side interdigital transducer and an other outermost electrode of said central interdigital transducer.

## Claims (Claims for the following Contracting State(s): FI)

1. A surface acoustic wave filter comprising:
a piezoelectric substrate, surface wave reflectors (503-1, 503-2; 703-1, 703-2) formed with an interval therebetween on said piezoelectric substrate, and interdigital transducers (501, 502-1, 502-2; 701, 702-1, 702-2) interposed between said surface wave reflectors (503-1, 503-2; 703-1, 703-2) on said piezoelectric substrate; wherein
said interdigital transducers comprise a central interdigital transducer (501; 701) for input, at least two side interdigital transducers (502-1, 502-2; 702-1, 702-2), at least one located at one of opposite sides of said central interdigital transducer (501; 701) and the other one located at the other one of opposite sides of said central interdigital transducer (501; 701),
said central interdigital transducer (501; 701) for input comprises a pair of first comb-like electrodes provided with an input terminal (504; 704) and second comb-like electrodes provided with a grounding terminal,
each of said side interdigital transducers (502-1, 502-2; 702-1, 702-2) for output comprises a pair of first comb-like electrodes provided with a connecting terminal and second comb-like electrodes provided with an output terminal (505-1, 505-2; 705-1. 705-2),
said output terminals (505-1, 505-2; 705-1, 705-2) are provided separately from each other so as to distribute one signal entering into said central interdigital transducer (501; 701) into at least two signals each outputted from each output terminal (505-1, 505-2; 705-1, 705-2) of said side interdigital transducers (502-1, 502-2; 702-1, 702-2), respectively, and
said connecting terminals are connected to each other and not connected to ground.

2. The surface acoustic wave filter according to claim 1, wherein the number of electrodes of said central interdigital transducer for input is substantially equal to that of each said side interdigital transducer for output.

3. The surface acoustic wave filter according to claim 1, wherein a space between said second comb-like electrodes provided with an outputting terminal of said first side interdigital transducer and said first comb-like electrodes provided with an inputting terminal of said central interdigital transducer is different at one or odd number times of half wavelength (λ/2) from a space between said second comb-like electrodes provided with an outputting terminal of said second side interdigital transducer and said first comb-like electrodes provided with an inputting, terminal of said central interdigital transducer, whereby one unbalanced input signal entering into said central interdigital transducer is distributed into at least two output signals having balanced relation to each other with respect to phase.

4. The surface acoustic wave filter according to claim 3, wherein the number of electrodes of each said side interdigital transducer for output is smaller than that of said central interdigital transducer for input so as to get a larger impedance of said side interdigital transducer.

5. The surface acoustic wave filter according to claim 3, wherein the space (ΔS₁) between an innermost electrode of said first side interdigitat transducer and one outermost electrode of said central interdigital transducer being different at one or odd number times of half wavelength (λ/2) from the space (ΔS₂) between an innermost electrode of said second side interdigital transducer and an other outermost electrode of said central interdigital transducer.

6. The surface acoustic wave filter according to claim 3, wherein the space (ΔS₃)between an innermost electrode of said first side interdigital transducer and one outermost electrode of said central interdigital transducer being substantially the same as the space (ΔS₂) between an innermost electrode of said second side interdigital transducer and an other outermost electrode of said central interdigital transducer.

## Patentansprüche (Patentansprüche für folgende(n) Vertragsstaat(en): DE, GB, SE)

1. Ein akustischer Oberflächenwellenfilter mit
einem piezo elektrischen Substrat, Oberflächenwellenreflektoren (503-1, 503-2; 703-1, 703-2), die mit einem dazwischen liegenden Abstand auf dem piezo elektrischen Substrat gebildet sind, und Interdigitalwandlern (501, 502-1, 502-2; 701, 702-1, 702-2), die zwischen den Oberflächenwellenreflektoren (503-1, 503-2; 703-1, 703-2) auf dem piezo elektrischen Substrat zwischengeschaltet sind, wobei
die Interdigitalwandler einen zentralen Interdigitalwandler (501; 701) zur Eingabe und wenigstens zwei seitliche Interdigitalwandler (502-1, 502-2; 702-1, 702-2) aufweisen, von denen wenigstens einer auf einer von gegenüberliegenden Seiten des zentralen Interdigitalwandlers (501; 701) und der andere auf der anderen von gegenüberliegenden Seiten des zentralen Interdigitalwandlers (501; 701) angeordnet ist,
der zentrale Interdigitalwandler (501; 701) zur Eingabe ein Paar von ersten kammartigen mit einem Eingangsanschluss (504; 704) versehenen Elektroden und zweiten kammartigen mit einem Erdungsanschluss versehenen Elektroden aufweist,
jeder der seitlichen Interdigitalwandler (502-1, 502-2; 702-1, 702-2) zur Ausgabe ein Paar von ersten kammartigen mit einem Verbindungsanschluss versehenen Elektroden und zweiten kammartigen mit einem Ausgangsanschluss (505-1, 505-2; 705-1, 705-2) versehenen Elektroden aufweist,
die Ausgangsanschlüsse (505-1, 505-2; 705-1, 705-2) getrennt voneinander bereitgestellt sind, so dass ein in den zentralen Interdigitalwandler (501; 701) eintretendes Signal in wenigstens zwei Signale verteilt wird, von denen jedes jeweils von jedem Ausgangsanschluss (505-1, 505-2; 705-1, 705-2) der seitlichen Interdigitalwandler (502-1, 502-2; 702-1, 702-2) ausgegeben wird und
die Verbindungsanschlüsse miteinander verbunden sind und nicht mit der Erde verbunden sind.

2. Akustischer Oberflächenwellenfilter nach Anspruch 1, bei dem die Anzahl von Elektroden des zentralen Interdigitalwandlers zur Eingabe im Wesentlichen gleich der eines jeden der seitlichen Interdigitalwandler zur Ausgabe ist.

3. Akustischer Oberflächenwellenfilter nach Anspruch 1, bei dem ein Abstand zwischen den zweiten kammartigen mit einem Ausgangsanschluss versehenen Elektroden des ersten seitlichen Interdigitalwandlers und den ersten kammartigen mit einem Eingangsanschluss versehenen Elektroden des zentralen Interdigitalwandlers um das einfache oder ungeradzahlige Vielfache der halben Wellenlänge (λ/2) verschieden ist von einem Abstand zwischen den zweiten kammartigen mit einem Ausgangsanschluss versehenen Elektroden des zweiten seitlichen Interdigitalwandlers und den ersten kammartigen mit einem Eingangsanschluss versehenen Elektroden des zentralen Interdigitalwandlers, wobei ein unsymmetrisches (unbalanced) Eingangssignal, das in den zentralen Interdigitalwandler eintritt in wenigstens zwei Ausgangssignale verteilt wird, die bzgl. der Phase eine symmetrische (balanced) Relation miteinander aufweisen.

4. Akustischer Oberflächenwellenfilter nach Anspruch 3, bei dem die Anzahl der Elektroden eines jeden seitlichen Interdigitalwandlers zur Ausgabe kleiner ist als die des zentralen Interdigitalwandlers zur Eingabe, damit eine größere Impedanz der seitlichen Interdigitalwandler erlangt wird.

5. Akustischer Oberflächenwellenfilter nach Anspruch 3, bei dem der Abstand zwischen einer innersten Elektrode des ersten seitlichen Interdigitalwandlers und einer äußersten Elektrode des zentralen Interdigitalwandlers um das einfache oder ungeradzahlige Vielfache der halben Wellenlänge (λ/2) verschieden ist von dem Abstand zwischen einer innersten Elektrode des zweiten seitlichen Interdigitalwandlers und einer äußersten Elektrode des zentralen Interdigitalwandlers.

6. Akustischer Oberflächenwellenfilter nach Anspruch 3, bei dem Abstand zwischen einer innersten Elektrode des ersten seitlichen Interdigitalwandlers und einer äußersten Elektrode des zentralen Interdigitalwandlers im Wesentlichen derselbe ist wie der Abstand zwischen einer innersten Elektrode des zweiten seitlichen Interdigitalwandlers und einer äußersten Elektrode des zentralen Interdigitalwandlers.

## Patentansprüche (Patentansprüche für folgende(n) Vertragsstaat(en): FI)

1. Ein akustischer Oberflächenwellenfilter mit
einem piezo elektrischen Substrat, Oberflächenwellenreflektoren (503-1, 503-2; 703-1, 703-2), die mit einem dazwischen liegenden Abstand auf dem piezo elektrischen Substrat gebildet sind, und Interdigitalwandlem (501, 502-1, 502-2; 701, 702-1, 702-2), die zwischen den Oberflächenwellenreflektoren (503-1, 503-2; 703-1, 703-2) auf dem piezo elektrischen Substrat zwischengeschaltet sind, wobei
die Interdigitalwandler einen zentralen Interdigitalwandler (501; 701) zur Eingabe und wenigstens zwei seitliche Interdigitalwandler (502-1, 502-2; 702-1, 702-2) aufweisen, von denen wenigstens einer auf einer von gegenüberliegenden Seiten des zentralen Interdigitalwandlers (501; 701) und der andere auf der anderen von gegenüberliegenden Seiten des zentralen Interdigitalwandlers (501; 701) angeordnet ist,
der zentrale Interdigitalwandler (501; 701) zur Eingabe ein Paar von ersten kammartigen mit einem Eingangsanschluss (504; 704) versehenen Elektroden und zweiten kammartigen mit einem Erdungsanschluss versehenen Elektroden aufweist,
jeder der seitlichen Interdigitalwandler (502-1, 502-2; 702-1, 702-2) zur Ausgabe ein Paar von ersten kammartigen mit einem Verbindungsanschluss versehenen Elektroden und zweiten kammartigen mit einem Ausgangsanschluss (505-1, 505-2; 705-1, 705-2) versehenen Elektroden aufweist,
die Ausgangsanschlüsse (505-1, 505-2; 705-1, 705-2) getrennt voneinander bereitgestellt sind, so dass ein in den zentralen Interdigitalwandler (501; 701) eintretendes Signal in wenigstens zwei Signale verteilt wird, von denen jedes jeweils von jedem Ausgangsanschluss (505-1, 505-2; 705-1, 705-2) der seitlichen Interdigitalwandler (502-1, 502-2; 702-1, 702-2) ausgegeben wird,
die Verbindungsanschlüsse miteinander verbunden sind und nicht mit der Erde verbunden sind und
die Anzahl der Elektroden eines jeden seitlichen Interdigitalwandlers zur Ausgabe kleiner ist als die des zentralen Interdigitalwandlers zur Eingabe, damit eine größere Impedanz der seitlichen Integralwandler erlangt wird.

2. Akustischer Oberflächenwellenfilter nach Anspruch 1, bei dem die Anzahl von Elektroden des zentralen Interdigitalwandlers zur Eingabe im Wesentlichen gleich der eines jeden der seitlichen Interdigitalwandler zur Ausgabe ist.

3. Akustischer Oberflächenwellenfilter nach Anspruch 1, bei dem ein Abstand zwischen den zweiten kammartigen mit einem Ausgangsanschluss versehenen Elektroden des ersten seitlichen Interdigitalwandlers und den ersten kammartigen mit einem Eingangsanschluss versehenen Elektroden des zentralen Interdigitalwandlers um das einfache oder ungeradzahlige Vielfache der halben Wellenlänge (λ/2) verschieden ist von einem Abstand zwischen den zweiten kammartigen mit einem Ausgangsanschluss versehenen Elektroden des zweiten seitlichen Interdigitalwandlers und den ersten kammartigen mit einem Eingangsanschluss versehenen Elektroden des zentralen Interdigitalwandlers, wobei ein unsymmetrisches (unbalanced) Eingangssignal, das in den zentralen Interdigitalwandler eintritt in wenigstens zwei Ausgangssignale verteilt wird, die bzgl. der Phase eine symmetrische (balanced) Relation miteinander aufweisen.

4. Akustischer Oberflächenwellenfilter nach Anspruch 1, bei dem der Abstand zwischen einer innersten Elektrode des ersten seitlichen Interdigitalwandlers und einer äußersten Elektrode des zentralen Interdigitalwandlers um das einfache oder ungeradzahlige Vielfache der halben Wellenlänge (λ/2) verschieden ist von dem Abstand zwischen einer innersten Elektrode des zweiten seitlichen Interdigitalwandlers und einer äußersten Elektrode des zentralen Interdigitalwandlers.

5. Akustischer Oberflächenwellenfilter nach Anspruch 1, bei dem Abstand zwischen einer innersten Elektrode des ersten seitlichen Interdigitalwandlers und einer äußersten Elektrode des zentralen Interdigitalwandlers im Wesentlichen derselbe ist wie der Abstand zwischen einer innersten Elektrode des zweiten seitlichen Interdigitalwandlers und einer äußersten Elektrode des zentralen Interdigitalwandlers.

## Revendications (Revendications pour l'(les) Etat(s) contractant(s) suivant(s): DE, GB, SE)

1. Filtre à ondes acoustiques de surface comprenant :
un substrat piézoélectrique, des réflecteurs d'onde de surface (503-1, 503-2 ; 703-1, 703-2) formés avec un intervalle entre eux sur ledit substrat piézoélectrique, et les transducteurs interdigités (501, 502-1, 502-2 ; 701, 702-1, 702-2) intercalés entre lesdits réflecteurs d'onde de surface (503-1, 503-2 ; 703-1, 703-2) sur ledit substrat piézoélectrique, dans lequel
lesdits transducteurs interdigités comprennent un transducteur interdigité central (501 ; 701) pour l'entrée, au moins deux transducteurs interdigités latéraux (502-1, 502-2 ; 702-1, 702-2), au moins l'un étant situé à l'un des côtés opposés dudit transducteur interdigité central (501 ; 701) et l'autre situé à l'autre des côtés opposés dudit transducteur interdigité central (501 ; 701),
ledit transducteur interdigité central (501 ; 701) pour l'entrée comprend une paire d'électrodes en forme de peigne munies d'une borne d'entrée (504 ; 704) et des secondes électrodes en forme de peigne munies d'une borne de mise à la masse,
chacun desdits transducteurs interdigités latéraux (502-1, 502-2 ; 702-1, 702-2) pour la sortie comprennent une paire de premières électrodes en forme de peigne munies d'une borne de connexion et de secondes électrodes en forme de peigne munies d'une borne de sortie (505-1, 505-2 ; 705-1, 705-2),
lesdites bornes de sortie (505-1, 505-2 ; 705-1, 705-2) sont prévues séparément l'une de l'autre de façon à répartir un signal entrant dans ledit transducteur interdigital central (501 ; 701) en au moins deux signaux, chacun fourni en sortie à partir de chaque borne de sortie (505-1, 505-2 ; 705-1, 705-2) desdits transducteurs interdigités latéraux (502-1, 502-2 ; 702-1, 702-2), respectivement, et
lesdites bornes de connexion sont reliées mutuellement et ne sont pas reliées à la masse.

2. Filtre à ondes acoustiques de surface selon la revendication 1, dans lequel le nombre d'électrodes dudit transducteur interdigité central pour l'entrée est sensiblement égal à celui de chaque dit transducteur interdigité latéral pour la sortie.

3. Filtre à ondes acoustiques de surface selon la revendication 1, dans lequel un espace entre lesdites secondes électrodes en forme de peigne munies d'une borne de sortie dudit premier transducteur interdigité latéral et lesdites premières électrodes en forme de peigne munies d'une borne d'entrée dudit transducteur interdigité central diffère d'une fois ou d'un nombre impair de fois de la demi-longueur d'onde (λ/2) d'un espace entre lesdites secondes électrodes en forme de peigne munies d'une borne de sortie dudit second transducteur interdigité latéral et desdites premières électrodes en forme de peigne munies d'une borne d'entrée dudit transducteur interdigité central, grâce à quoi un signal d'entrée asymétrique entrant dans ledit transducteur interdigité central est réparti en au moins deux signaux de sortie présentant une relation d'équilibre l'un par rapport à l'autre en ce qui concerne la phase.

4. Filtre à ondes acoustiques de surface selon la revendication 3, dans lequel le nombre d'électrodes de chaque dit transducteur interdigité latéral pour la sortie est inférieur à celui dudit transducteur interdigité central pour l'entrée de façon à obtenir une impédance plus grande dudit transducteur interdigité latéral.

5. Filtre à ondes acoustiques de surface selon la revendication 3, dans lequel l'espace (ΔS₁) entre une électrode la plus à l'intérieur dudit premier transducteur interdigité latéral et une électrode la plus à l'extérieur dudit transducteur interdigité central diffère d'une fois ou d'un nombre impair de fois de la demi-longueur d'onde (λ/2), de l'espace (ΔS₂) entre une électrode la plus à l'intérieur dudit second transducteur interdigité latéral et d'une autre électrode la plus à l'extérieur dudit transducteur interdigité central.

6. Filtre à ondes acoustiques de surface selon la revendication 3, dans lequel l'espace (ΔS₃) entre une électrode la plus à l'intérieur dudit premier transducteur interdigité latéral et une électrode la plus à l'extérieur dudit transducteur interdigité central est sensiblement le même que l'espace (ΔS₂) entre une électrode la plus à l'intérieur dudit second transducteur interdigité latéral et une autre électrode la plus à l'extérieur dudit transducteur interdigité central.

## Revendications (Revendications pour l'(les) Etat(s) contractant(s) suivant(s): FI)

1. Filtre à ondes acoustiques de surface comprenant :
un substrat piézoélectrique, des réflecteurs d'onde de surface (503-1, 503-2 ; 703-1, 703-2) formés avec un intervalle entre eux sur ledit substrat piézoélectrique, et Des transducteurs interdigités (501, 502-1, 502-2 ; 701, 702-1, 702-2) intercalés entre lesdits réflecteurs d'onde de surface (503-1, 503-2 ; 703-1, 703-2) sur ledit substrat piézoélectrique, dans lequel
lesdits transducteurs interdigités comprennent un transducteur interdigité central (501 ; 701) pour l'entrée, au moins deux transducteurs interdigités latéraux (502-1, 502-2 ; 702-1, 702-2), au moins l'un étant situé à l'un des côtés opposés dudit transducteur interdigité central (501 ; 701) et l'autre situé à l'autre des côtés opposés dudit transducteur interdigité central (501 ; 701),
ledit transducteur interdigité central (501 ; 701) pour l'entrée comprend une paire d'électrodes en forme de peigne munies d'une borne d'entrée (504 .; 704) et des secondes électrodes en forme de peigne munies d'une borne de mise à la masse,
chacun desdits transducteurs interdigités latéraux (502-1, 502-2 ; 702-1, 702-2) pour la sortie comprennent une paire de premières électrodes en forme de peigne munies d'une borne de connexion et de secondes électrodes en forme de peigne munies d'une borne de sortie (505-1, 505-2 ; 705-1, 705-2),
lesdites bornes de sortie (505-1, 505-2 ; 705-1, 705-2) sont prévues séparément l'une de l'autre de façon à répartir un signal entrant dans ledit transducteur interdigital central (501 ; 701) en au moins deux signaux, chacun fourni en sortie à partir de chaque borne de sortie (505-1, 505-2 ; 705-1, 705-2) desdits transducteurs interdigités latéraux (502-1, 502-2 ; 702-1, 702-2), respectivement,
lesdites bornes de connexion sont reliées mutuellement et ne sont pas reliées à la masse, et
le nombre d'électrodes de chaque dit transducteur interdigité latéral pour la sortie est inférieur à celui dudit transducteur interdigité central pour l'entrée de façon à obtenir une impédance plus grande dudit transducteur interdigité latéral.

2. Filtre à ondes acoustiques de surface selon la revendication 1, dans lequel le nombre d'électrodes dudit transducteur interdigité central pour l'entrée est sensiblement égal à celui de chaque dit transducteur interdigité latéral pour la sortie.

3. Filtre à ondes acoustiques de surface selon la revendication 1, dans lequel un espace entre lesdites secondes électrodes en forme de peigne munies d'une borne de sortie dudit premier transducteur interdigité latéral et lesdites premières électrodes en forme de peigne munies d'une borne d'entrée dudit transducteur interdigité central diffère d'une fois ou d'un nombre impair de fois de la demi-longueur d'onde (λ/2), d'un espace entre lesdites secondes électrodes en forme de peigne munies d'une borne de sortie dudit second transducteur interdigité latéral et desdites premières électrodes en forme de peigne munies d'une borne d'entrée dudit transducteur interdigité central, grâce à quoi un signal d'entrée asymétrique entrant dans ledit transducteur interdigité central est réparti en au moins deux signaux de sortie présentant une relation d'équilibre l'un par rapport à l'autre en ce qui concerne la phase.

4. Filtre à ondes acoustiques de surface selon la revendication 1, dans lequel l'espace (ΔS₁) entre une électrode la plus à l'intérieur dudit premier transducteur interdigité latéral et une électrode la plus à l'extérieur dudit transducteur interdigité central diffère d'une fois ou d'un nombre impair de fois de la demi-longueur d'onde (λ/2) de l'espace (ΔS₂), entre une électrode la plus à l'intérieur dudit second transducteur interdigité latéral et de l'autre électrode la plus extérieur dudit transducteur interdigité central.

5. Filtre à ondes acoustiques de surface selon la revendication 1, dans lequel l'espace (ΔS₃) entre une électrode la plus à l'intérieur dudit premier transducteur interdigité latéral et une électrode la plus à l'extérieur dudit transducteur interdigité central est sensiblement le même que l'espace (ΔS₂) entre une électrode la plus à l'intérieur dudit second transducteur interdigité latéral et une autre électrode la plus à l'extérieur dudit transducteur interdigité central.
